# EUROPEAN PATENT SPECIFICATION

(11) **EP 0 574 858 B1**
(45) Date of publication and mention of the grant of the patent: **12.03.1997**
(21) Application number: 93109469.2
(22) Date of filing: 14.06.1993
(51) Int. Cl.: C23G 1/14

(54) **Inorganic oxidant compositions for removing contaminants**
Anorganische oxydierende Zusammensetzungen zur Entfernung von Verunreinigungen
Compositions inorganiques oxydantes pour éliminer les contaminants

(30) Priority: 19.06.1992 US 901297
(43) Date of publication of application: 22.12.1993
(73) Proprietor: Hughes Aircraft Company, Los Angeles, California 90080-0028 (US)
(72) Inventor: Elias, William E., El Segundo, California 90245 (US); George, Richard C., Topanga, California 90290 (US); Stanford, Thomas B., San Pedro, California 90731 (US)
(74) Representative: KUHNEN, WACKER & PARTNER

(56) References cited:
- WO-A-91/09987
- WO-A-93/10280
- DE-A- 2 911 259
- FR-A- 1 423 432
- US-A- 4 578 162

## Description

### BACKGROUND OF THE INVENTION

### 1. Field of the Invention

The present invention relates generally to a composition and method for removing contaminants from solid substrates. More particularly, the present invention relates to an oxidizing composition for removing inorganic contaminants and organic contaminants, such as solder flux; and to a method for using this composition.

### 2. Description of the Background Art

In the fabrication of printed circuit assemblies, integrated circuits, and various electronic components and devices, solder is used to join various component metal parts together. The solder itself comprises an alloy, such as of zinc and copper or of tin and lead. Prior to application of the solder to the metal surface, the surface is treated with a fluxing agent to remove oxides and other contaminants which might interfere with the metal bonding, and to prevent reformation thereof during the solder process. These fluxing agents are typically organic materials such as natural rosin extracted from pine tree sap, organic acids such as carboxylic acids, hydrazines, amines, and amides, or inorganic materials such as inorganic acids or salts.

The most commonly used fluxing agent is rosin flux. The term "rosin flux" is used herein to mean a flux material which comprises rosin, i.e., the resin after distilling turpentine from the exudation of species of pine, and containing abietic acid and its anhydride. Typically, a small amount of another acid is added to rosin flux to activate it and such compositions are referred to as "acid rosin flux" or "rosin activated flux".

After the solder operation has been completed, excess flux as well as flux residues remain on the soldered surface. These flux residues are resinous, waxy, and electrically conductive. These flux residues and excess flux must be removed prior to subsequent processing steps in order to prevent reaction thereof with the soldered part, leading to corrosion and resultant electrical insulation losses.

Defluxing agents which are widely used at present are halogenated hydrocarbons such as 1,1,1-trichloroethane and the FREONs (FREON is a tradename of E. I. DuPont de Nemours for polyhalogenated hydrocarbons including chlorine and fluorine). While these organic materials are effective defluxing solvents, they have the serious disadvantage that they have a negative impact on the environment due to ozone depletion. In fact, recent environmental legislation mandates that these materials be ultimately banned and their production severely restricted in the next few years. When these materials are used, even in small quantities, expensive management systems for transport, storage, use, and disposal must be employed, together with the use of environmental protection equipment. In addition, waste solvents require energy-intensive regeneration operations for these materials.

A new and improved composition and method for removing such organic flux residues and excess flux and indeed for removing organic materials in general from substrates has been disclosed in WO91/09987.

The composition comprises (a) hydrogen peroxide in the amount of about 3 to 5 percent by weight of the composition; (b) an alkaline compound in sufficient amount to provide a pH of at least about 10.5 in the composition; (c) a chosen wetting agent in the amount of about 0.1 to 0.3 percent by weight of the composition, the wetting agent being unreactive with the hydrogen peroxide and the alkaline compound; and (d) purified water as the balance of the composition. Optionally, the composition may further comprise a chosen metal protective agent in the amount of about 0.5 to 2.0 percent by weight of the composition, the metal protective agent also being unreactive with the hydrogen peroxide and the alkaline compound.

An additional improvement in the removal of organic flux residues and other organic contaminants has been disclosed and claimed in WO-A-93/10280.

In accordance with this improvement, contaminants are removed from a solid substrate by a process comprising (a) providing an initial reaction bath comprising an alkaline compound, a wetting agent, and deionized water, (b) metering hydrogen peroxide into the initial and final reaction baths at a rate of at least about 0.004 milligrams of hydrogen peroxide per minute per gallon^{*)} of reaction bath fluid, (c) sparging the initial and final reaction baths with air or oxygen at a rate of about 0.001 to 1 standard cubic feet^{**)} per minute, and (d) exposing the substrate having contaminants to the final reaction bath containing metered hydrogen peroxide and sparging air or oxygen.
*) 1 gallon ≙ 3.79ℓ
**) 1 foot ≙ 30.5 cm

Exposure of the solid substrate having organic contaminants thereon to the above-described compositions results in removal of the organic contaminants from the substrate. These contaminants are converted into non-toxic and non-hazardous products, thereby avoiding negative environmental impact.

While the foregoing compositions, which comprise aqueous solutions and processes are, well-suited for their intended purposes, hydrogen peroxide can degrade certain materials, and itself tends to break down quickly (by mechanical and chemical forces). Thus, a need exists for extending the technology represented by the hydrogen peroxide approach to overcome its existing limitations while retaining its advantages.

### SUMMARY OF THE INVENTION

In accordance with the invention, a new and improved composition and method for removing contaminants from a chosen solid substrate while avoiding negative environmental impact are provided. This composition and method possess the advantages of the hydrogen peroxide composition and process, while overcoming its tendency to degrade some materials and to break down and become inactive if unreplenished.

The composition of the invention may comprise one of two alternatives to the hydrogen peroxide composition of the prior art. In the first alternative, chemicals are employed which produce hydrogen peroxide when they are dissolved in water. The balance of the composition comprises an alkaline compound, a wetting agent, and deionized water.

In the second alternative, other oxidizing species are employed in place of hydrogen peroxide. These other oxidizing species must be non-damaging to the substrates and to any components mounted thereon, not damaging to the environment, non-explosive, cost effective, and reactive in heated water. Specifically, the salts of halogen oxy-acids have been found to be effective in reacting with the organic flux residues and other contaminants and produce the reaction products which are dispersible in the solution of the invention.

The composition of the invention comprises:
(a) an oxidizer selected from the group of (1) oxidizing agents which generate hydrogen peroxide upon dissolution in water, the oxidizing agent present in an amount sufficient to generate from about 0.01 percent by weight of hydrogen peroxide based on said composition when dissolved in water up to the solubility limit of said oxidizing agent in said composition, and (2) salts of halogen oxy-acids, present in an amount of about 0.01 percent by weight of said composition when dissolved in water up to the solubility limit of said salt halogen oxy-acid in said composition;
(b) an alkaline compound in sufficient amount to provide a pH of 7.0 or higher in the composition when dissolved in water, and
(c) a chosen wetting agent in the amount of about 0.01 to 5.0 percent by weight of the composition when dissolved in water, the wetting agent being unreactive with the oxidizer and the alkaline compound.
The method of the invention comprises: a method for removing contaminants from a chosen solid substrate while simultaneously avoiding negative environmental impact, said method comprising:
(a) providing a composition comprising
   (1) an oxidizer selected from the group of (i) oxidizing agents which generate hydrogen peroxide upon dissolution in water, said oxidizing agent present in an amount sufficient to generate from about 0.01 percent weight of hydrogen peroxide based on said composition when dissolved in water up to the solubility limit of said oxidizing agent in said composition, and (ii) salts of halogen oxy-acids, present in an amount of about 0.01 percent by weight of said composition when dissolved in water up to the solubility limit of said salt of halogen oxy-acid in said composition,
   (2) an alkaline compound in sufficient amount to provide a pH of 7.0 or higher in said composition when dissolved in water, and
   (3) a chosen wetting agent in the amount of about 0.01 to 5.0 percent by weight of said composition, said wetting agent being unreactive with said oxidizer and said alkaline compound, and
(b) adding deionized water as the balance of said composition; and
(c) exposing said solid substrate having said contaminants to said composition, whereby said contaminants are removed from said substrate and converted into non-toxic and non-hazardous products.

The contaminants are removed from a chosen solid substrate and converted into non-toxic products in a manner which avoids negative environmental impact.

### DESCRIPTION OF THE PREFERRED EMBODIMENTS

The composition of the present invention is effective for removing contaminants from a solid substrate while at the same time avoiding undesirable impact on the environment. While not so limited, the composition of the present invention is especially useful for removing flux residues which contaminate surfaces after a soldering operation. These flux residues typically comprise resinous, waxy contaminants which are the breakdown products from the soldering operation. The substrates which are soldered may comprise, for example, printed wiring boards, integrated circuits, electronic components, electronic devices, electronic connectors, or electronic cables. In accordance with the present invention, the by-products, such as carbon dioxide, nitrogen, and water, which are formed are non-hazardous and can be removed without having a negative environmental impact.

The composition in accordance with the present invention comprises: (a) an oxidizer selected from the group of (1) oxidizing agents which generate hydrogen peroxide upon dissolution in water, the oxidizing agent present in an amount sufficient to generate from about 0.01 percent by weight of hydrogen peroxide based on the composition up to the solubility limit of the oxidizing agent in the composition, and (2) salts of halogen oxy-acids, present in an amount from about 0.01 percent by weight of the composition up to the solubility limit of the salt of the halogen oxy-acid in the composition; (b) an alkaline compound in a sufficient amount to provide a pH of 7.0 or higher in the composition; (c) a chosen wetting agent which is unreactive with the oxidizer and the alkaline compound and which is present in the amount of about 0.01 to 5.0 percent by weight of the composition; and (d) deionized water as the balance of the composition. Optionally, a materials protective agent is added to protect the surface of the substrate and associated structures from attack by the oxidizer and alkali. The materials protective agent is unreactive with the oxidizer and the alkaline compound and is present in the amount of about 0.01 to 10.0 percent by weight of the composition.

The composition of the invention may comprise one of two alternatives as the oxidizer. In the first alternative, chemicals are employed which produce hydrogen peroxide when they are dissolved in water. The use of these peroxide-generating chemicals in the present composition has the advantage that these chemicals have stable shelf-lives and may be stored until needed. This first alternative avoids the prior art problem of the break down of hydrogen peroxide over time. In addition, these peroxide-generating chemicals, in some cases, also produce an alkaline material that contributes to the maintenance of the required pH, as discussed below.

The lower limit of the amount of the peroxide-generating chemical is the amount required to generate and maintain a minimum of about 0.01 percent by weight of hydrogen peroxide in the final composition during the cleaning process. The upper limit of the peroxide-generating chemical is the solubility limit of this chemical in the final composition. If the peroxide-generating chemical is added in a single addition, a higher amount of this chemical is added initially and the amount of peroxide will decrease over time. If the peroxide-generating chemical is continuously metered into the cleaning bath, as described in said WO-A-93/10280, then the lower limit of the peroxide-generating chemical may be initially added and maintained.

Examples of reactive chemical species which generate hydrogen peroxide upon dissolution in water include the salts of persulfates, peroxides, percarbonates, perborates, superoxides, organic peroxy acid-salts, and peroxyhydrates (i.e., inorganic atoms with hydrogen peroxide physically captured in the crystal structure). In addition to generating hydrogen peroxide, peroxide salts generate hydroxides, percarbonates generate carbonates, perborates generate borates, and superoxides generate hydroxides. As previously discussed, these alkaline materials contribute to the maintenance of the required pH in the composition. The cation of the salt may be any cation which produces a water-soluble salt, and preferably is an alkali metal, most preferably sodium. Preferred peroxide-generating chemicals for practicing the present invention include potassium persulfate, sodium peroxide, and potassium perborate.

In the second alternative, other oxidizing species are employed in place of the peroxide-generating chemical. These other oxidizing species must be non-damaging to the substrates and to any components mounted thereon, not damaging to the environment, non-explosive, cost effective, and reactive in heated water. Specifically, the salts of halogen oxy-acids have been found to be effective for reacting with the organic flux residues and other contaminants in a slightly different mechanism than hydrogen peroxide and produce reaction products which are dispersible in the solution of the invention.

The salts of halogen oxy-acids are typically added in a single addition, but optionally may be metered. The lower limit of the amount of the halogen oxy-acid salt is about 0.01 percent by weight of the final composition, and the upper limit is the solubility limit of this material in the final composition.

Examples of suitable salts of halogen oxy-acids include the salts of hypochlorites, hypobromites, hypoiodites, chlorites, bromites, iodites, bromates, iodates, and periodates. Preferred salts of halogen oxy-acids for practicing the present invention include bromates and iodates. The cation of the salt may be any cation which produces a water-soluble salt, and preferably is an alkali metal, most preferably sodium.

The present composition further comprises an alkaline compound which is added in sufficient amount to provide a pH above 7.0. Alkaline formulations having a pH of greater than about 10.0 are considerably more effective at solubilizing the flux residues than acid or neutral solutions. Thus, the alkaline compound is added to the present composition to provide a pH of at least 10.0, preferably within the range of about 10.0 to 13.5. The alkaline compound may be, for example, sodium hydroxide, potassium hydroxide, sodium metasilicate, sodium carbonate, or sodium borate, with sodium hydroxide being most preferred. If sodium hydroxide is used to provide a pH greater than 10.0, it is present in the amount of about 0.05 to 5.0 percent by weight of the composition. In addition, as previously discussed, many of the peroxide-generating chemicals of the present invention also generate alkaline compounds, such as hydroxides, carbonates, and borates, which contribute to the pH of the present composition. The cation of the alkaline compound may be any cation which produces a water-soluble salt, such as sodium, potassium, lithium, or cerium.

The wetting agent used in the present composition must be chosen to be compatible with the other components in the composition. Conventional wetting agents such as sodium alkylaryl sulfonate and other organic synthetic detergents decompose rapidly in the presence of strong alkaline oxidizing/bleaching solutions such as the composition of the present invention. This results in rapid decomposition of the oxidizer and excessive foaming in the solution. A preferred wetting agent for use in the present composition comprises 2-ethylhexyl sulfate (obtained from Niacet Company, Niagara Falls, New York). It has good solubility, stability, and penetrating action in near-boiling alkaline and acid solutions, and is one of the few anionic surfactants stable in concentrated bleaching solutions. Other suitable wetting agents comprise the series of compounds sold by Air Products and Chemicals of Allentown, Pennsylvania under the trademark "SURFYNOL", which are non-ionic acetylene diols and their ethoxylated analogs. Specific examples include SURFYNOL 104, 420, 440, 465, and 485. Still other suitable wetting agents for practicing the present invention may comprise short-chain branched aliphatic surfactants. The wetting agent is used in the present invention in the amount of about 0.01 to 5.0 percent by weight of the composition.

The wetting agent is preferably used in the minimum amount required to produce the desired surface tension, such as about 0,3 - 0,4 mN cm⁻¹ (30 to 40 dyne-centimeter) or lower, but larger amounts of the wetting agent may be used, up to the limit at which phase separation of the wetting agent occurs. In addition, if the present composition is used in an apparatus employing spraying of the composition above the surface of the cleaning bath, it is desirable that the cleaning solution include a low foaming wetting agent.

The effectiveness of the composition of the present invention is believed to be due to a synergistic relationship between the specific oxidizer chemistry, pH chemistry, and the wetting agent.

If the substrate comprises a metal or metal alloy, such as in a printed wiring board, the metal surface must be protected from attack by the oxidizer and alkali in the present solution. The particular metal protective agent used depends on the specific metal being protected. For example, calcium and phosphorus compounds are used as protective agents for copper. The selection of the particular protective agent for a particular metal is known in the art and need not be detailed here. Suitable materials protective agents for metals for practicing the present invention include sodium metasilicate, sodium carbonate, or esters of phosphate, phosphonate, or phosphite compounds. If the substrate includes structures formed of plastic, ceramic, or other materials as described herein, a suitable materials protective agent for the specific material is incorporated in the present composition. Such materials protective agents are known in the art and need not be discussed in detail here. The materials protective agent is present in the amount of about 0.01 to 10.0 percent by weight of the composition. The materials protective agent must be unreactive with the oxidizer and the alkaline compound and must be capable of being easily removed from the substrate with a water rinse.

An operating temperature within the range of about 32° to 100°C may be used. A preferred temperature for use is about 70°C. The increased temperature promotes the reaction, improves penetration of the composition by softening gummy contaminants, and keeps particulates in suspension so that they do not deposit on the cleaned substrates. In addition, the elevated temperature optimizes the effectiveness of ultraviolet radiation, if used, for cleaving bonds in organic materials, as described below.

The optimum operating temperature of the present composition to provide effective contaminant removal within a short period of time is within the range of about 51.7° to 71.1°C. Within this range, flux contaminants may be removed within about 5 minutes or less. The amount of time required to remove contaminants from a substrate depends on numerous factors, such as the type of equipment used, the temperature, pressure, and flow rate of the composition, the distance of the substrate from the spray nozzles, if used, and the type and complexity of the substrate being cleaned.

The contaminants which can be removed in accordance with the present invention comprise both organic materials and inorganic materials. Organic materials include, but are not limited to, the residues left by commonly used solder flux materials. These flux materials comprise oils, resins, and other organic materials. Since the present composition and method are effective for cleaving carbon-to-carbon bonds, they may be used for the removal of other organic compounds as well. Such materials include, but are not limited to, oil, grease, lubricants, photoresist, masking materials, adhesive residues, plasticizers, and dyes. The present invention is also effective for removing inorganic contaminants, which include, but are not limited to, acids used as flux activators, such as hydrochloric acid, hydrobromic acid, hydrofluoric acid, or sulfuric acid, and salts, such as zinc chloride, which is used as a flux.

The solid substrate from which contaminants can be removed in accordance with the present invention may comprise any material which is not adversely affected by the oxidizer or alkaline components of the present composition. Such materials include, but are not limited to, polyimide/polyamide laminates and epoxy/glass laminates which are used in printed wiring boards, silicon which is used in electronic devices, and anodized aluminum or polyimide which are used in cables and connectors. The solid substrate may have a simple or complex configuration and may include interstitial spaces which are difficult to clean by known methods. The substrate may be in the form of a continuous layer or in the form of discrete particles.

The solid substrate may be comprised of various materials, such as metal, plastic, or ceramic materials. For example, parts used on a printed wiring board often include plastic spacers or component bodies, metal heat sinks, brackets, nuts, bolts, or screws or ceramics. When such materials are used, the present composition includes a materials protective agent, as described herein to protect these materials from attack by the oxidizer and alkali.

In accordance with an alternative embodiment of the present invention, ultraviolet radiation is used to enhance the cleaning process. When the hydrogen peroxide formed from one of the peroxide-generating chemicals is exposed to ultraviolet radiation having a wavelength within the range of 184 to 300 nanometers (nm), preferably about 253 nm, such as from a xenon flash lamp, the peroxide is dissociated to form a hydroxyl radical (OH⁻) which is very reactive. This hydroxyl radical then cleaves the carbon-to-carbon bonds in the organic contaminant material, forming carbon dioxide and water. In addition, for both types of oxidizing agents used in the present composition, the ultraviolet radiation itself also cleaves the carbon-to-carbon bonds in the contaminant material, adding even further effectiveness to the cleaning process. The source of ultraviolet radiation, such as a xenon flash lamp or a mercury vapor lamp, is located external to the chamber containing the substrate to be cleaned and the present composition, and the radiation is directed into the cleaning chamber. For this purpose, a quartz window is provided on one surface of the cleaning chamber to permit transmission of the ultraviolet radiation. Optionally, a focusing barrel may be provided between the quartz window and the radiation source to improve the efficiency of the ultraviolet radiation transmission. Such methods for introducing radiation into reaction chambers are well-known.

The composition of the present invention may be used in essentially the same manner as known defluxing agents are used; namely, in a spray or soak operation. If used in a soak operation, it is desirable to keep the present composition agitated, as by air or mechanical or ultrasonic means. After treatment with the present invention, the substrate is rinsed with a high volume spray of hot water and then dried with hot air. As an option, after the substrate has been treated with the present composition, residual alkaline materials (alkali or alkali salts) remaining on the substrate are neutralized. A preferred neutralization agent comprises hot carbonated water, which is applied at about 51.7° to 71.1°C, preferably with air agitation, and then dried, preferably with hot air. In an exemplary batch processing technique, in which contaminated substrates are loaded into a chamber and treated, in turn, with the present composition, neutralizing agent, water, and hot air, the following approximate processing times may typically be used:

| Step | Time |
|---|---|
| a. Exposure of contaminated substrate to present composition | 3 minutes |
| b. Neutralization | 2 minutes |
| c. Hot water rinse | 2 minutes |
| d. Hot air drying | 3 minutes |

Alternatively, the present process can be practiced as a "batch in-line" process. The contaminated substrates are loaded into a rack and the rack is lowered in sequence into a series of chambers containing, respectively, the present composition, the neutralizing agent (if used), and deionized water sprayers. As yet another alternative, this inline processing may be accomplished by a conveyorized system.

After the substrate has been treated with the present composition, the substrate is removed from the chamber containing the composition. The starting composition is then re-established by the addition of oxidizer and, if necessary, the other components of the composition. It has been determined that a build-up of treated residues does not affect the performance of the present composition for a considerable amount of time. Consequently, the residue does not need to be removed after each treatment. However, if it is desired to dispose of the spent bath through the sewage lines, the amount of contaminants in the bath must not be allowed to exceed legally specified limits for such disposal.

As an added feature of the present invention, the present composition removes metallic oxides from the substrate.

### EXAMPLES

A test matrix was constructed, in which hot, stirred cleaning solution was used to remove baked-on flux from underneath glass slides. The gaps between the glass slides and the substrate varied from 5 mil (1.27 micrometer) to 1 mil (0.25 micrometer) gaps, to create various degrees of difficulty in cleaning.

Glass slides were glued down to a glass substrate by applying small dots of adhesive to each corner. The gap or standoff distance from the plate was controlled to be 5 mil (1.27 micrometer) or 3 mil (0.76 micrometer) or 1 mil (0.25 micrometer). The glass test coupons had Alpha 611 flux (Alpha Metals, Inc.) applied, to fill up the gap between the slide and substrate. To simulate actual processing, the fluxed test coupons were baked in air at 220°C for 5 minutes. Within 3 hours, the baked-out test coupons were evaluated in the various cleaning solutions.

Each of the various oxidizers tested was incorporated into the following cleaning solution composition:

| | |
|---|---|
| 3 to 8 wt% | oxidizer |
| 0.33 wt% | sodium hydroxide |
| 1.00 wt% | sodium carbonate |
| 0.20 wt% | NIAPROOF 08 (sodium ethylhexyl sulfate; Niacet Corp.) |
| 0.50 wt% | sodium metasilicate (anhydrous) |
| balance | deionized water. |

The oxidizers were added to the 160°F (71°C) solution of the above composition. The immersion times in the magnetically stirred solution ranged from 5 to 30 minutes.

As previously discussed, the amount of time required to remove contaminants from a substrate depends on numerous factors which require optimization. It should be noted that the results described below were achieved without any such optimization. Consequently, it is anticipated that even more effective and rapid contaminant removal can be achieved using the composition and method of the present invention when various factors are optimized.

The test coupons were visually inspected continuously during exposure to the cleaning solution.

### Example 1:

The first oxidizer employed was 3 wt% sodium peroxide in the above solution. When sodium peroxide is dissolved in water, it is equivalent to a solution of hydrogen peroxide and sodium hydroxide. After 5 minutes exposure, all the surface flux was removed and about 3% of the entrapped flux was removed. After a total of 20 minutes immersion time, approximately 15% of the entrapped flux was removed.

### Example 2:

The next oxidizer studied was potassium persulfate. An aqueous solution of potassium persulfate is equivalent to potassium sulfate and hydrogen peroxide. Since potassium persulfate has an equivalent weight of 270 (compared to 34 for hydrogen peroxide), an 8 wt% solution of potassium persulfate was employed in the above formulation to achieve an equivalent hydrogen peroxide composition of 1.3%. After a 5 minute immersion time, all surface flux was removed and 1 to 2% entrapped flux was removed. After a total of 20 minutes immersion time, approximately 15 to 20% entrapped flux was removed.

### Example 3:

In this example, the oxidizer comprised 4 wt% potassium bromate. After 5 minutes, all surface flux was removed. A total immersion time of 30 minutes removed 60 to 80% of entrapped flux.

### Example 4:

In this example, the oxidizer compound comprised 3 wt% sodium hypochlorite. A 5 minute immersion time removed all surface flux and about 5% entrapped flux. After a total of 20 minutes immersion time, about 10% entrapped flux was removed.

Calcium hypochlorite was tested, but the calcium ion precipitated in the alkaline solution. This result showed that all potential cations for the present oxidizer agent must be soluble in alkaline water solution.

Other types of oxidizers may be employed, such as chromates, dichromates, and permanganates. However, these compounds have the major disadvantage that they present heavy metal waste disposal problems. In alkaline solutions, the permanganates are more active than the chromates.

### Example 5 (Comparative Example):

A 4 wt% solution of potassium permanganate in the above formulation was prepared. After a 5 minute immersion time, there was very little surface flux removed and no entrapped flux was removed. In addition, a brownish particulate film was left covering the test coupon.

## Claims

1. A composition for removing contaminants from a chosen solid substrate by decomposing said contaminants into non-hazardous by-products, said composition comprising:
(a) an oxidizer selected from the group of
(1) oxidizing agents which generate hydrogen peroxide upon dissolution in water, said oxidizing agent present in an amount sufficient to generate from about 0.01 percent by weight of hydrogen peroxide based on said composition when dissolved in water up to the solubility limit of said oxidizing agent in said composition, and
(2) salts of halogen oxy-acids, present in an amount of about 0.01 percent by weight of said composition when dissolved in water up to the solubility limit of said salt of said halogen oxy-acid in said composition;
(b) an alkaline compound in sufficient amount to provide a pH of 7.0 or higher in said composition when dissolved in water; and
(c) a chosen wetting agent in the amount of about 0.01 to 5.0 percent by weight of said composition when dissolved in water, said wetting agent being unreactive with said oxidizer and said alkaline compound.

2. The composition of claim 1 wherein said oxidizing agents which generate hydrogen peroxide upon dissolution in water are selected from the group consisting of salts of persulfates, peroxides, percarbonates, perborates, superoxides, peroxy acid-salts, and peroxyhydrates.

3. The composition of claim 1 or 2 wherein said salts of halogen oxy-acids are selected from the group consisting of the salts of hypochlorites, hypobromites, hypoiodites, chlorites, bromites, iodites, bromates, iodates, and periodates.

4. The composition of any of claims 1-3 wherein said alkaline compound is selected from the group consisting of water-soluble salts of hydroxides, carbonates, and silicates.

5. The composition of any of claims 1-4 wherein said wetting agent is selected from the group consisting of 2-ethylhexyl sulfate, non-ionic acetylenic diols and ethoxylated analogs thereof, and short-chain branched aliphatic surfactants.

6. The composition of claim 1 further comprising a chosen materials protective agent in the amount of about 0.01 to 10.0 percent by weight of said composition, said materials protective agent being unreactive with said oxidizing agent and said alkaline compound.

7. A method for removing contaminants from a chosen solid substrate while simultaneously avoiding negative environmental impact, said method comprising:
(a) providing a composition comprising:
(1) an oxidizer selected from the group of (i) oxidizing agents which generate hydrogen peroxide upon dissolution in water, said oxidizing agent present in an amount sufficient to generate from about 0.01 percent by weight of hydrogen peroxide based on said composition when dissolved in water up to the solubility limit of said oxidizing agent in said composition, and (ii) salts of halogen oxy-acids, present in an amount of about 0.01 percent by weight of said composition when dissolved in water up to the solubility limit of said salt of halogen oxy-acid in said composition,
(2) an alkaline compound in sufficient amount to provide a pH of 7.0 or higher in said composition when dissolved in water, and
(3) a chosen wetting agent in the amount of about 0.01 to 5.0 percent by weight of said composition, said wetting agent being unreactive with said oxidizer and said alkaline compound
(b) adding deionized water as the balance of said composition; and
(c) exposing said solid substrate having said contaminants to said composition, whereby said contaminants are removed from said substrate and converted into non-toxic and non-hazardous products.

8. The method of claim 7 wherein said exposing is performed with said composition at a temperature within the range of about 32° to 100°C.

9. The method of claim 7 and/or 8 further comprising after said exposing said substrate to said composition, neutralizing residial said alkaline compound or products thereof on said substrate, rinsing said substrate with water, and drying said substrate.

10. The method of any of claims 7-9 wherein said exposing in step "c" further comprises exposing said composition and said contaminants an said substrate to ultraviolet radiation having a wavelenght within the range of 184 to 300 nanometers.

## Patentansprüche

1. Zusammensetzung zum Entfernen von Verunreinigungen von einem ausgewählten festen Substrat durch Zersetzen der Verunreinigungen in ungefährliche Nebenprodukte, wobei die Zusammensetzung folgendes enthält:
(a) ein Oxidationsmittel, ausgewählt aus der Gruppe von
(1) Oxidationsmitteln, welche beim Auflösen in Wasser Wasserstoffperoxid entwickeln, wobei das Oxidationsmittel in einer Menge vorhanden ist, die ausreicht, um beim Auflösen in Wasser bis zu der Löslichkeitsgrenze des Oxidationsmittels in der Zusammensetzung ungefähr 0,01 Gew.-% an Wasserstoffperoxid zu entwickeln, bezogen auf die Zusammensetzung, und
(2) Salze von Halogensauerstoffsäuren, welche beim Auflösen in Wasser bis zu der Löslichkeitsgrenze des Salzes der Halogensauerstoffsäure in der Zusammensetzung in einer Menge von ungefähr 0,01 Gew.-% der Zusammensetzung vorhanden sind;
(b) eine alkalische Verbindung in einer ausreichenden Menge, um beim Auflösen in Wasser in der Zusammensetzung einen pH von 7,0 oder höher zur Verfügung zu stellen; und
(c) ein ausgewähltes Benetzungsmittel in der Menge von ungefähr 0,01 bis 5,0 Gew.-% der Zusammensetzung, beim Auflösen in Wasser, wobei das Benetzungsmittel nicht mit dem Oxidationsmittel und der alkalischen Verbindung reagiert.

2. Zusammensetzung gemäß Anspruch 1, wobei die Oxidationsmittel, welche beim Auflösen in Wasser Wasserstoffperoxid erzeugen, aus der Gruppe ausgewählt sind, bestehend aus Salzen von Persulfaten, Peroxiden, Percarbonaten, Perboraten, Superoxiden, Peroxysäuresalzen und Peroxyhydraten.

3. Zusammensetzung gemäß Anspruch oder 2, wobei die Salze der Halogensauerstoffsäuren aus der Gruppe ausgewählt sind, bestehend aus den Salzen der Hypochlorite, Hypobromite, Hypoiodite, Chlorite, Bromite, Iodite, Bromate, Jodate und Periodate.

4. Zusammensetzung gemäß einem der Ansprüche 1 - 3, wobei die alkalische Verbindung aus der Gruppe ausgewählt ist, bestehend aus wasserlöslichen Salzen von Hydroxiden, Carbonaten und Silicaten.

5. Zusammensetzung gemäß einem der Ansprüche 1 - 4, wobei das Benetzungsmittel aus der Gruppe ausgewählt ist, bestehend aus 2-Ethylhexylsulfat, nichtionischen Acetylendiolen und deren ethoxylierten Analogen und kurzkettigen verzweigten aliphatischen Tensiden.

6. Zusammensetzung gemäß Anspruch 1, welche ferner ein Schutzmittel für das ausgewählte Material in einer Menge von ungefähr 0,01 bis 10,0 Gew.-% der Zusammensetzung enthält, wobei das Materialschutzmittel nicht mit dem Oxidationsmittel und der alkalischen Verbindung reagiert.

7. Verfahren zum Entfernen von Verunreinigungen von einem ausgewählten festen Substrat während gleichzeitig eine negative Auswirkung auf die Umwelt verhindert wird, wobei das Verfahren folgendes umfaßt:
(a) Zur-Verfügung-Stellen einer Zusammensetzung, welche folgendes enthält:
(1) ein Oxidationsmittel ausgewählt aus der Gruppe aus (i) Oxidationsmitteln, welche beim Auflösen in Wasser Wasserstoffperoxid entwickeln, wobei das Oxidationsmittel in einer Menge vorhanden ist, die ausreicht, um beim Auflösen in Wasser bis zu der Löslichkeitsgrenze des Oxidationsmittels in der Zusammensetzung ungefähr 0,01 Gew.-% an Wasserstoffperoxid zu entwickeln, bezogen auf die Zusammensetzung, und (ii) Salze von Halogensauerstoffsäuren, welche beim Auflösen in Wasser bis zu der Löslichkeitsgrenze des Salzes der Halogensauerstoffsäure in der Zusammensetzung in einer Menge von ungefähr 0,01 Gew.-% der Zusammensetzung vorhanden sind,
(2) eine alkalische Verbindung in einer ausreichenden Menge, um beim Auflösen in Wasser in der Zusammensetzung einen pH von 7,0 oder höher zur Verfügung zu stellen; und
(3) ein ausgewähltes Benetzungsmittel in der Menge von ungefähr 0,01 bis 5,0 Gew.-% der Zusammensetzung, wobei das Benetzungsmittel nicht mit dem Oxidationsmittel und der alkalischen Verbindung reagiert.
(b) Zugeben von entionisiertem Wasser als der Ausgleich der Zusammensetzung; und
(c) der Zusammensetzung Aussetzen des festen Substrates mit den Verunreinigungen, wobei die Verunreinigungen vom Substrat entfernt und in ungiftige und ungefährliche Produkte umgewandelt werden.

8. Verfahren gemäß Anspruch 7, wobei das Aussetzen mit der Zusammensetzung bei einer Temperatur innerhalb des Bereiches von ungefähr 32 bis 100°C durchgeführt wird.

9. Verfahren gemäß Anspruch 7 und/oder 8, welches ferner nach dem der Zusammensetzung Aussetzen des Substrates ein Neutralisieren der restlichen alkalischen Verbindung oder deren Produkte auf dem Substrat enthält, wobei das Substrat mit Wasser gespült und das Substrat getrocknet wird.

10. Verfahren gemäß einem der Ansprüche 7 - 9, wobei das Aussetzen in Schritt c ferner das Aussetzen der Zusammensetzung und der Verunreinigungen und des Substrates einer ultravioletten Strahlung mit einer Wellenlänge innerhalb des Bereiches von 184 bis 300 Nanometer enthält.

## Revendications

1. Composition pour éliminer les contaminants d'un substrat solide choisi par décomposition de ces contaminants en sous-produits non dangereux, ladite composition comprenant :
(a) un oxydant choisi dans le groupe consistant en
(1) des agents oxydants qui engendrent du peroxyde d'hydrogène par dissolution dans l'eau, un tel agent oxydant étant présent en une quantité suffisante pour engendrer d'environ 0,01 pour cent en poids de peroxyde d'hydrogène sur la base de ladite composition lors de la dissolution dans l'eau jusqu'à la limite de solubilité dudit agent oxydant dans ladite composition, et
(2) des sels d'oxacides halogénés, présents en une quantité d'environ 0,01 pour cent en poids de ladite composition lors de la dissolution dans l'eau jusqu'à la limite de solubilité dudit sel dudit oxacide halogéné dans ladite composition ;
(b) un composé alcalin en une quantité suffisante pour engendrer un pH égal ou supérieur à 7,0 dans ladite composition lors de la dissolution dans l'eau ; et
(c) un agent mouillant choisi en une quantité d'environ 0,01 à 5,0 pour cent en poids de ladite composition lors de la dissolution dans l'eau, ledit agent mouillant étant non réactif avec ledit oxydant et ledit composé alcalin.

2. Composition suivant la revendication 1, dans laquelle les agents oxydants qui engendrent du peroxyde d'hydrogène par dissolution dans l'eau sont choisis dans le groupe consistant en persulfates, peroxydes, percarbonates, perborates, superoxydes, sels de peroxacides et peroxyhydrates.

3. Composition suivant la revendication 1 ou 2, dans laquelle les sels d'oxacides halogénés sont choisis dans le groupe consistant en les hypochlorites, hypobromites, hypoiodites, chlorites, bromites, iodites, bromates, iodates et periodates.

4. Composition suivant l'une quelconque des revendications 1 à 3, dans laquelle le composé alcalin est choisi dans le groupe consistant en sels hydrosolubles qui sont des hydroxydes, des carbonates et des silicates.

5. Composition suivant l'une quelconque des revendications 1 à 4, dans laquelle l'agent mouillant est choisi dans le groupe consistant en sulfate de 2-éthylhexyle, diols acétyléniques non ioniques et leurs analogues éthoxylés, ainsi que des surfactants aliphatiques ramifiés à chaîne courte.

6. Composition suivant la revendication 1, comprenant en outre un agent choisi de protection des matériaux, en une quantité d'environ 0,01 à 10,0 pour cent en poids de ladite composition, ledit agent de protection des matériaux étant non réactif avec l'agent oxydant et le composé alcalin.

7. Procédé pour éliminer les contaminants d'un substrat solide choisi tout en évitant simultanément un effet négatif sur l'environnement, ledit procédé comprenant les étapes consistant :
(a) à prendre une composition comprenant :
(1) un oxydant choisi dans le groupe consistant en (i) des agents oxydants qui engendrent du peroxyde d'hydrogène par dissolution dans l'eau, un tel agent oxydant étant présent en une quantité suffisante pour engendrer environ 0,01 pour cent en poids de peroxyde d'hydrogène sur la base de ladite composition lors de la dissolution dans l'eau jusqu'à la limite de solubilité dudit agent oxydant dans ladite composition et (ii) des sels d'oxacides halogénés, présents en une quantité d'environ 0,01 pour cent en poids de ladite composition lors de la dissolution dans l'eau jusqu'à la limite de solubilité dudit sel d'oxacide halogéné dans ladite composition,
(2) un composé alcalin en une quantité suffisante pour engendrer un pH égal ou supérieur à 7,0 dans ladite composition lors de la dissolution dans l'eau, et
(3) un agent mouillant choisi en une quantité d'environ 0,01 à 5,0 pour cent en poids de ladite composition, ledit agent mouillant étant non réactif avec ledit oxydant et ledit composé alcalin,
(b) à ajouter de l'eau désionisée pour compléter ladite composition ; et
(c) à mettre en contact ledit substrat solide portant lesdits contaminants avec ladite composition, ce qui permet d'éliminer lesdits contaminants dudit substrat et de transformer ces contaminants en produits non toxiques et non dangereux.

8. Procédé suivant la revendication 7, dans lequel la mise en contact est effectuée avec la composition à une température comprise dans l'intervalle d'environ 32° à 100°C.

9. Procédé suivant la revendication 7 et/ou la revendication 8, comprenant en outre, après la mise en contact du substrat avec la composition, la neutralisation du composé alcalin résiduel ou de ses produits sur ledit substrat, le rinçage dudit substrat avec de l'eau et le séchage de ce substrat.

10. Procédé suivant l'une quelconque des revendications 7 à 9, dans lequel la mise en contact dans l'étape (c) comprend en outre l'exposition de la composition et des contaminants présents sur le substrat à un rayonnement ultraviolet ayant une longueur d'onde comprise dans l'intervalle de 184 à 300 nanomètres.
